(19) 

Europäisches
Patentamt
European
Patent Office
Office européen
des brevets

(11) **EP 4 745 603 A1**

(12) **EUROPEAN PATENT APPLICATION**
published in accordance with Art. 153(4) EPC

(43) Date of publication:
    **20.05.2026  Bulletin 2026/21**

(21) Application number: 25852591.4

(22) Date of filing: **27.05.2025**

(51) International Patent Classification (IPC):
    **G01R 31/392** *(2019.01)*    **G01R 31/396** *(2019.01)*
    **G01R 31/367** *(2019.01)*

(86) International application number:
    **PCT/CN2025/097529**

(87) International publication number:
    **WO 2026/045427 (05.03.2026 Gazette 2026/10)**

(84) Designated Contracting States:
    **AL AT BE BG CH CY CZ DE DK EE ES FI FR GB
    GR HR HU IE IS IT LI LT LU LV MC ME MK MT NL
    NO PL PT RO RS SE SI SK SM TR**
    Designated Extension States:
    **BA**
    Designated Validation States:
    **GE KH LA MA MD TN**

(30) Priority:  **03.04.2025  CN 202510425713**

(71) Applicant: **Eve Energy Co., Ltd.**
    **Huizhou, Guangdong 516006 (CN)**

(72) Inventors:
    • **LIU, Junwen**
      **Huizhou, Guangdong 516006 (CN)**

    • **DONG, Yapeng**
      **Huizhou, Guangdong 516006 (CN)**
    • **PAN, Anjin**
      **Huizhou, Guangdong 516006 (CN)**
    • **LI, Wei**
      **Huizhou, Guangdong 516006 (CN)**
    • **HU, Zhiwei**
      **Huizhou, Guangdong 516006 (CN)**
    • **ZHANG, Siquan**
      **Huizhou, Guangdong 516006 (CN)**
    • **WANG, Chenhao**
      **Huizhou, Guangdong 516006 (CN)**

(74) Representative: **Prinz & Partner mbB**
    **Patent- und Rechtsanwälte**
    **Rundfunkplatz 2**
    **80335 München (DE)**

(54) **METHOD FOR PREDICTING BATTERY STATE OF HEALTH OF VEHICLE, AND ELECTRONIC DEVICE AND STORAGE MEDIUM**

(57)    Provided are a method for predicting a battery state of health of a vehicle, an electronic device, and a storage medium. The method includes the following: the vehicle parameter information of the vehicle at the n-th occasion is acquired (S110), where the vehicle parameter information includes the operating parameters of the vehicle and the parameter information of a battery pack, and n is an integer greater than or equal to 1; the multi-dimensional feature data at an (n - 1)-th occasion is acquired (S120), where the multi-dimensional feature data includes the data of the battery state of health at the (n - 1)-th occasion; the multi-dimensional feature data at the n-th occasion is calculated according to the vehicle parameter information at the n-th occasion and the multi-dimensional feature data at the (n - 1)-th occasion (S130); and the battery state of health at the n-th occasion is determined based on a preset prediction model.

```
                                                          ┌─ S110
┌─────────────────────────────────────────────────────┐
│ Acquire the vehicle parameter information of the     │
│ vehicle at the n-th occasion                         │
└─────────────────────────────────────────────────────┘
                                                          ┌─ S120
┌─────────────────────────────────────────────────────┐
│ Acquire the multi-dimensional feature data at the    │
│ (n − 1)-th occasion, where the multi-dimensional     │
│ feature data includes the data of the battery        │
│ state of health at the (n − 1)-th occasion           │
└─────────────────────────────────────────────────────┘
                                                          ┌─ S130
┌─────────────────────────────────────────────────────┐
│ Calculate the multi-dimensional feature data at the  │
│ n-th occasion according to the vehicle parameter     │
│ information at the n-th occasion and the multi-       │
│ dimensional feature data at the (n − 1)-th occasion  │
└─────────────────────────────────────────────────────┘
                                                          ┌─ S140
┌─────────────────────────────────────────────────────┐
│ Determine the battery state of health at the n-th    │
│ occasion based on a preset prediction model and      │
│ according to the multi-dimensional feature data at   │
│ the n-th occasion and the data of the battery state  │
│ of health at the (n − 1)-th occasion                 │
└─────────────────────────────────────────────────────┘
```

**FIG. 1**

EP 4 745 603 A1

**Description**

The present application claims priority to Chinese Patent Application No. 202510425713.0 filed with the China National Intellectual Property Administration (CNIPA) on Apr. 3, 2025, the disclosure of which is incorporated herein by reference in its entirety.

TECHNICAL FIELD

The present application relates to the field of battery detection technology, for example, a method for predicting a battery state of health of a vehicle, an electronic device, and a storage medium.

BACKGROUND

Current batteries are widely used in fields like automobiles and electronic mobile devices. Due to the recycling of a battery, an irreversible physical or chemical change may occur inside the battery. The battery state of health may continue to decline with use. Therefore, in order to guarantee the safe operation of the battery, it is necessary to detect the battery state of health.

TECHNICAL PROBLEM

For the battery detection technology in the related art, it has a relatively poor performance in predicting the battery state of health and a relatively low precision.

TECHNICAL SOLUTION

According to an aspect of the present application, a method for predicting a battery state of health of a vehicle is provided. The method includes the steps below.

Vehicle parameter information of the vehicle at an n-th occasion is acquired, where the vehicle parameter information includes operating parameters of the vehicle and parameter information of a battery pack, and n is an integer greater than or equal to 1.

Multi-dimensional feature data at an (n - 1)-th occasion is acquired, wherein the multi-dimensional feature data includes data of a battery state of health at the (n - 1)-th occasion.

Multi-dimensional feature data at the n-th occasion is calculated according to the vehicle parameter information at the n-th occasion and the multi-dimensional feature data at the (n - 1)-th occasion.

A battery state of health at the n-th occasion is determined based on a preset prediction model and according to the multi-dimensional feature data at the n-th occasion and the data of the battery state of health at the (n - 1)-th occasion.

According to another aspect of the present disclosure, an electronic device is provided. The electronic device includes at least one processor and a memory communicatively connected to the at least one processor.

The memory stores a computer program executable by the at least one processor. The computer program, when executed by the at least one processor, causes the at least one processor to perform the method for predicting a battery state of health of a vehicle in any embodiment of the present application.

According to another aspect of this application, a computer-readable storage medium is provided. The computer-readable storage medium stores computer instructions which, when executed by a processor, cause the processor to perform the method for predicting a battery state of health of a vehicle in any embodiment of the present application.

BENEFICIAL EFFECTS

In some embodiments of the present application, the operating parameters of the vehicle and the parameter information of the battery pack can be acquired simultaneously by acquiring the vehicle parameter information at the n-th occasion and the multi-dimensional feature data at the (n - 1)-th occasion, thereby guaranteeing more comprehensive data information. Therefore, the present application has better accuracy and precision in the prediction of the battery state of health. Additionally, the present application does not limit the type of the battery in the prediction of the battery state of health and may be applied to various types of batteries such as lithium iron phosphate, ternary lithium battery, lithium manganese iron phosphate, and lithium cobalt oxide, thereby having relatively high applicability.

BRIEF DESCRIPTION OF DRAWINGS

FIG. 1 is a flowchart of a method for predicting a battery state of health of a vehicle according to some embodiments of the present application.

FIG. 2 is a flowchart of another method for predicting a battery state of health of a vehicle according to some embodiments of the present application.

FIG. 3 is a flowchart of an implementation of S132 according to some embodiments of the present application.

FIG. 4 is a flowchart of another method for predicting a battery state of health of a vehicle according to some embodiments of the present application.

FIG. 5 is a flowchart of an implementation of S135 according to some embodiments of the present application.

FIG. 6 is a flowchart of another method for predicting a battery state of health of a vehicle according to some embodiments of the present application.

FIG. 7 is a flowchart of another method for predicting a battery state of health of a vehicle according to some embodiments of the present application.

FIG. 8 is a diagram illustrating the structure of an electronic device according to some embodiments of the present application.

DETAILED DESCRIPTION

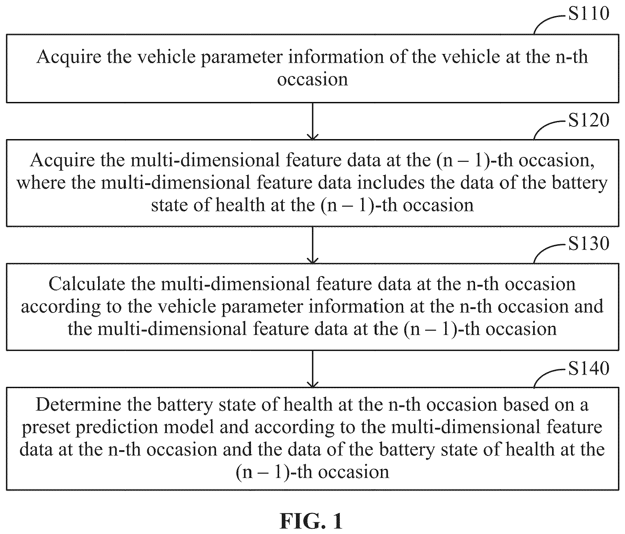

Embodiments of the present application provide a method for predicting a battery state of health of a vehicle. FIG. 1 is a flowchart of a method for predicting a battery state of health of a vehicle according to embodiments of the present application. Referring to FIG. 1, the method includes the steps below.

In S110, the vehicle parameter information of the vehicle at the n-th occasion is acquired.

The vehicle parameter information includes the operating parameters of the vehicle and the parameter information of a battery pack. The operating parameters of the vehicle may include data like the driving mileage of the vehicle and the operating time of the vehicle. The parameter information of the battery pack may include information like the real-time charging temperature of the battery pack, the charging capacity of the battery pack, and the voltage of the battery pack. N is an integer greater than or equal to 1. The n-th occasion is a occasion when the vehicle parameter information is acquired for the n-th time.

Exemplarily, at each acquisition occasion, information may be acquired actively when it is necessary to predict the battery state of health. Alternatively, information may be automatically acquired every 500 kilometers (km) or every month of operation of the vehicle. Then the subsequent prediction of the battery state of health is performed. The vehicle parameter information may be acquired through a cloud server. The cloud server provides a powerful computing capability. The vehicle parameter information may be stored in the cloud server in the form of a state of health (SOH) tag. Moreover, multi-dimensional feature data is calculated through the cloud server. Therefore, the SOH tag may be used for reflecting the detailed data of the vehicle parameter information. When data extraction or processing is performed, data collection may be carried out by extracting the SOH tag, which has a more efficient collection efficiency.

In S120, the multi-dimensional feature data at the (n - 1)-th occasion is acquired. The multi-dimensional feature data includes the data of the battery state of health at the (n - 1)-th occasion.

The multi-dimensional feature data may be calculated from the vehicle parameter information. The multi-dimensional feature data at the (n - 1)-th occasion may be used for reflecting the vehicle parameter information at the (n - 1)-th occasion. Exemplarily, the multi-dimensional feature data at the (n - 1)-th occasion may be obtained from the vehicle parameter information at the (n - 1)-th occasion and the multi-dimensional feature data at the (n - 2)-th occasion.

Exemplarily, the data of the battery state of health at the zeroth occasion is a preset initial health value. If the battery at this occasion is a brand-new battery, the preset initial health value may be 100%.

In S130, the multi-dimensional feature data at the n-th occasion is calculated according to the vehicle parameter information at the n-th occasion and the multi-dimensional feature data at the (n - 1)-th occasion.

The multi-dimensional feature data at the (n - 1)-th occasion includes the data of the battery state of health at the (n - 1)-th occasion. The multi-dimensional feature data at the n-th occasion can be calculated according to the vehicle parameter information at the n-th occasion and the multi-dimensional feature data at the (n - 1)-th occasion. It is to be noted that the multi-dimensional feature data at the n-th occasion calculated in this step does not include the battery state of health at the n-th occasion.

In S140, the battery state of health at the n-th occasion is determined based on a preset prediction model and according to the multi-dimensional feature data at the n-th occasion and the data of the battery state of health at the (n - 1)-th occasion.

In some embodiments, the preset prediction model may be, for example, an eXtreme Gradient Boosting (XGBoost) model or a Gradient Boosting Tree (GBT) model. The multi-dimensional feature data and the data of the battery state of health are used as the input of the preset prediction model, and the battery state of health is used as the output of the preset prediction model.

The preset prediction model may output the battery state of health at the n-th occasion after the multi-dimensional feature data at the n-th occasion and the data of the battery state of health at the (n - 1)-th occasion are input into the preset prediction model. The data input to the preset prediction model includes the operating parameters of the vehicle, the parameter information of the battery pack, and the data of the battery state of health at the (n - 1)-th occasion so that the preset prediction model can generate the battery state of health according to the abundant data. The preset prediction model can perform more comprehensive data processing due to the input of various data, thereby improving the precision of the output data.

According to the technical solutions provided in embodiments of the present application, the operating parameters of the vehicle and the parameter information of the battery pack can be acquired simultaneously by acquiring the vehicle parameter information at the n-th occasion and the multi-dimensional feature data at the (n - 1)-th occasion, thereby guaranteeing more comprehensive data information. Therefore, the present application has better accuracy and precision in the prediction of the battery state of health. Additionally, the present application does not limit the type of the battery in the prediction of the battery state of health and may be applied to various types of batteries such as lithium iron phosphate, ternary lithium battery, lithium manganese iron phosphate, and lithium cobalt oxide, thereby having relatively high applicability.

On the basis of each preceding embodiment, optionally, S110 in which the vehicle parameter information of the vehicle at the n-th occasion is acquired includes that the operating parameters of the vehicle and the parameter information of the battery pack at the n-th occasion are acquired. The operating parameters of the vehicle include the driving mileage of the vehicle and the operating time of the vehicle. The parameter information of the battery pack includes the real-time charging temperature of the battery pack, the real-time fast charging capacity of the battery pack, the real-time slow charging capacity of the battery pack, and the voltages of all battery cells.

The driving mileage of the vehicle is the total mileage of the vehicle after the vehicle is put into operation. The operating time of the vehicle is the continuous operating time after the vehicle is started.

Exemplarily, multiple sampling points may exist between various occasions, and the vehicle collects the vehicle parameter information at each sampling point. For example, the vehicle may collect the vehicle parameter information every 10 seconds (s). When it is necessary to acquire the driving mileage of the vehicle, the driving mileage of the vehicle can be obtained through the field of accumulated driving mileage. When it is necessary to acquire the operating time of the vehicle, the operating time of the vehicle may be obtained through the operating time of the vehicle at each sampling point.

Therefore, the driving mileage of the vehicle is the sum of the driving mileage between all the sampling points, and the operating time of the vehicle is the sum of the operating time of the vehicle between each sampling point.

The real-time charging temperature of the battery pack is the temperature of the battery pack collected at each sampling point when the battery pack is charged. The real-time fast charging capacity of the battery pack is the sum of the fast charging capacity of the battery pack between each sampling point when the battery pack is charged. The real-time low charging capacity of the battery pack is the sum of the low charging capacity of the battery pack between each sampling point when the battery pack is charged. The voltages of all the battery cells are the voltages of various battery cells inside the battery pack when the battery pack is fully charged.

Embodiments of the present application provide richer data in the prediction of the battery state of health by acquiring the operation parameters of the vehicle and the parameter information of the battery pack, greatly improving the precision in the prediction of the battery state of health and having a relatively sound prediction effect.

On the basis of each preceding embodiment, optionally, S130 in which the multi-dimensional feature data at the n-th occasion is calculated according to the vehicle parameter information at the n-th occasion and the multi-dimensional feature data at the (n - 1)-th occasion includes that the vehicle mileage data at the n-th occasion is calculated according to the driving mileage of the vehicle at the n-th occasion and the vehicle mileage data of the multi-dimensional feature data at the (n - 1)-th occasion.

In some embodiments, multi-dimensional feature data includes vehicle mileage data. The vehicle mileage data may include the driving mileage of the vehicle and the daily average driving mileage of the vehicle. The driving mileage of the vehicle and the daily average driving mileage of the vehicle are negatively correlated with the battery state of health. Exemplarily, the more the driving mileage of the vehicle and the more the daily average driving mileage of the vehicle, the lower the battery state of health.

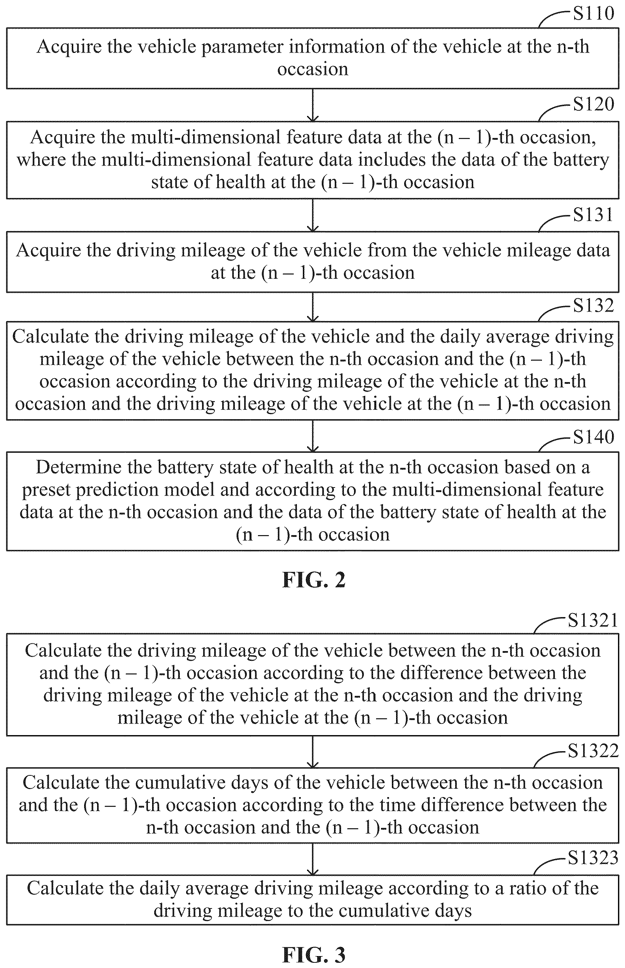

FIG. 2 is a flowchart of another method for predicting a battery state of health of a vehicle according to embodiments of the present application. Referring to FIG. 2, on the basis of each preceding embodiment, optionally, that the vehicle mileage data at the n-th occasion is calculated according to the driving mileage of the vehicle at the n-th occasion and the vehicle mileage data of the multi-dimensional feature data at the (n - 1)-th occasion includes the steps below.

In S131, the driving mileage of the vehicle is acquired from the vehicle mileage data at the (n - 1)-th occasion.

In S132, the driving mileage of the vehicle and the daily average driving mileage of the vehicle between the n-th occasion and the (n - 1)-th occasion are calculated according to the driving mileage of the vehicle at the n-th occasion and the driving mileage of the vehicle at the (n - 1)-th occasion.

In some embodiments, vehicle mileage data includes driving mileage and daily average driving mileage. The driving mileage of the vehicle between the n-th occasion and the (n - 1)-th occasion can be obtained by subtracting the driving mileage of the vehicle at the (n - 1)-th occasion from the driving mileage of the vehicle at the n-th occasion. Then the daily average driving mileage of the vehicle between the n-th occasion and the (n - 1)-th occasion can be obtained by dividing the driving mileage between the n-th occasion and the (n - 1)-th occasion by the total number of days between the n-th occasion and the (n - 1)-th occasion.

FIG. 3 is a flowchart of an implementation of S132 according to embodiments of the present application. Referring to FIG. 3, on the basis of each preceding embodiment, optionally, S132 in which the driving mileage of the vehicle and the daily average driving mileage of the vehicle between the n-th occasion and the (n - 1)-th occasion are calculated according to the driving mileage of the vehicle at the n-th occasion and the driving mileage of the vehicle at the (n - 1)-th occasion includes the steps below.

In S1321, the driving mileage of the vehicle between the n-th occasion and the (n - 1)-th occasion is calculated according to the difference between the driving mileage of the vehicle at the n-th occasion and the driving mileage of the vehicle at the (n - 1)-th occasion.

The driving mileage of the vehicle at the n-th occasion is the total driving mileage of the vehicle from the zeroth occasion to the n-th occasion. The driving mileage of the vehicle at the (n - 1)-th occasion is the total driving mileage of the vehicle from the zeroth occasion to the (n - 1)-th occasion. The driving mileage of the vehicle between the n-th occasion and the (n - 1)-th occasion can be obtained by subtracting the driving mileage of the vehicle at the (n - 1)-th occasion from the driving mileage of the vehicle at the n-th occasion.

In S1322, the cumulative days of the vehicle between the n-th occasion and the (n - 1)-th occasion are calculated according to the time difference between the n-th occasion and the (n - 1)-th occasion.

Two sampling occasions may be any occasions. The cumulative days between the n-th occasion and the (n - 1)-th occasion can be obtained by comparing the difference between the n-th occasion and the (n - 1)-th occasion and converting the difference into a 24-hour (h) format.

In S1323, the daily average driving mileage is calculated according to a ratio of the driving mileage to the cumulative days.

The daily average driving mileage can be obtained by dividing the driving mileage of the vehicle between the n-th occasion and the (n - 1)-th occasion by the cumulative days. The daily average driving mileage is the vehicle's average driving mileage per day between the n-th occasion and the (n - 1)-th occasion.

In the present application, the calculation of the vehicle mileage data is implemented through the acquisition and calculation of the driving mileage and the daily average driving mileage, thereby enriching the multi-dimensional feature data.

On the basis of each preceding embodiment, optionally, S130 in which the multi-dimensional feature data at the n-th occasion is calculated according to the vehicle parameter information at the n-th occasion and the multi-dimensional feature data at the (n - 1)-th occasion includes that the vehicle operating data at the n-th occasion is calculated according to the operating time of the vehicle at the n-th occasion and the vehicle operating data of the multi-dimensional feature data at the (n - 1)-th occasion.

In some embodiments, multi-dimensional feature data further includes vehicle operating data. The vehicle operating data may include the operating time of the vehicle. The operating time of the vehicle is the starting time of the vehicle between two occasions. That is, the longer the operating time of the vehicle, the longer the starting time of the vehicle and the greater the amount of the electricity used. Therefore, an increase in the operating time of the vehicle may also affect the battery state of health.

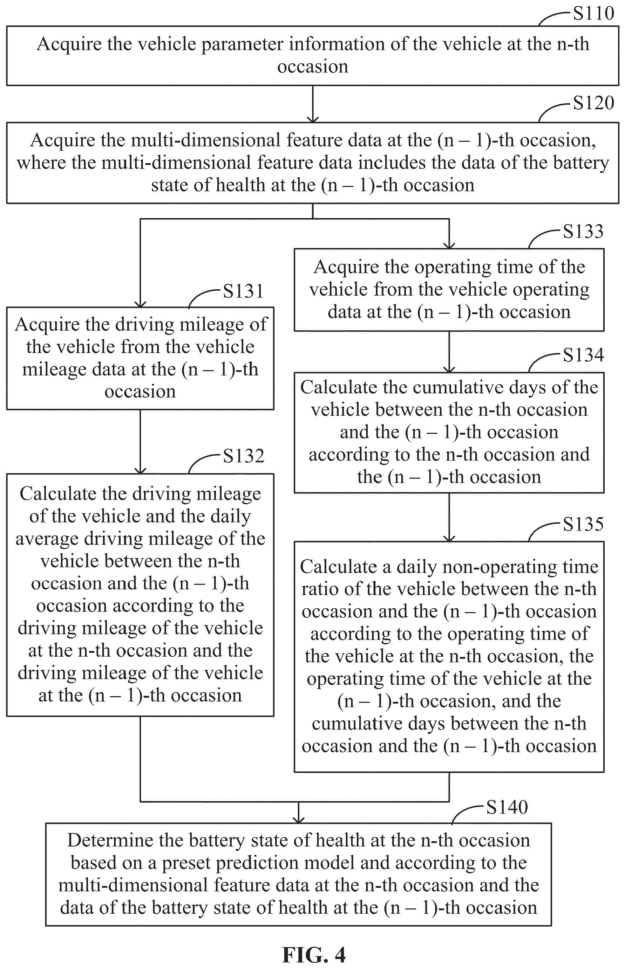

FIG. 4 is a flowchart of another method for predicting a battery state of health of a vehicle according to embodiments of the present application. Referring to FIG. 4, on the basis of each preceding embodiment, optionally, that the vehicle operating data at the n-th occasion is calculated according to the operating time of the vehicle at the n-th occasion and the vehicle operating data of the multi-dimensional feature data at the (n - 1)-th occasion includes the steps below.

In S133, the operating time of the vehicle is acquired from the vehicle operating data at the (n - 1)-th occasion.

In S134, the cumulative days of the vehicle between the n-th occasion and the (n - 1)-th occasion is calculated according to the n-th occasion and the (n - 1)-th occasion.

In S135, a daily non-operating time ratio of the vehicle between the n-th occasion and the (n - 1)-th occasion is calculated according to the operating time of the vehicle at the n-th occasion, the operating time of the vehicle at the (n - 1)-th occasion, and the cumulative days between the n-th occasion and the (n - 1)-th occasion.

In some embodiments, vehicle operating data includes a daily non-operating time ratio. The operating time of the vehicle between the n-th occasion and the (n - 1)-th occasion can be obtained by subtracting the operating time of the vehicle at the (n - 1)-th occasion from the operating time of the vehicle at the n-th occasion. Then the non-operating time of the vehicle between the n-th occasion and the (n - 1)-th occasion can be obtained by subtracting the operating time between the n-th occasion and the (n - 1)-th occasion from the total time between the n-th occasion and the (n - 1)-th occasion. Later the daily non-operating time ratio can be obtained by dividing the non-operating time by the total time of the cumulative days. The daily non-operating time ratio is a ratio of the non-operating time of the vehicle to the total time in a day.

The technical solutions provided in embodiments of the present application do not limit the execution order of step S131 and step S133. After step S120, either step S131 may be performed first, or step S133 may be performed first.

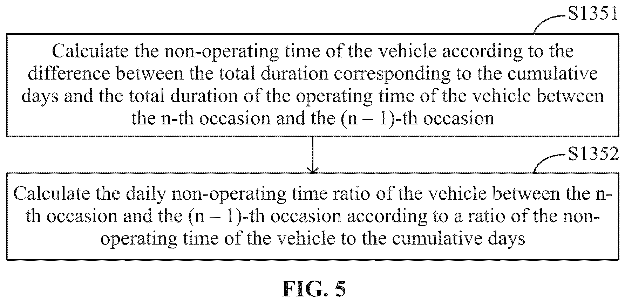

FIG. 5 is a flowchart of an implementation of S135 according to embodiments of the present application. Referring to FIG. 5, on the basis of each preceding embodiment, optionally, S135 in which the daily non-operating time ratio of the vehicle between the n-th occasion and the (n - 1)-th occasion is calculated according to the operating time of the vehicle at the n-th occasion, the operating time of the vehicle at the (n - 1)-th occasion, and the cumulative days between the n-th occasion and the (n - 1)-th occasion includes the steps below.

In S1351, the non-operating time of the vehicle is calculated according to the difference between the total duration corresponding to the cumulative days and the total duration of the operating time of the vehicle between the n-th occasion and the (n - 1)-th occasion.

The operating time of the vehicle at the n-th occasion is the total operating time of the vehicle from the zeroth occasion to the n-th occasion. The operating time of the vehicle at the (n - 1)-th occasion is the total operating time of the vehicle from the zeroth occasion to the (n - 1)-th occasion. The operating time of the vehicle between the n-th occasion and the (n - 1)-th occasion can be obtained by subtracting the operating time of the vehicle at the (n - 1)-th occasion from the operating time of the vehicle at the n-th occasion.

Then the non-operating time of the vehicle can be obtained through the difference between the total duration corresponding to the cumulative days and the total duration of the operating time between the n-th occasion and the (n - 1)-th occasion.

In S1352, the daily non-operating time ratio of the vehicle between the n-th occasion and the (n - 1)-th occasion is calculated according to a ratio of the non-operating time of the vehicle to the cumulative days.

The daily non-operating time ratio can be obtained by dividing the non-operating time of the vehicle between the n-th occasion and the (n - 1)-th occasion by the total duration corresponding to the cumulative days of the vehicle between the n-th occasion and the (n - 1)-th occasion.

On the basis of each preceding embodiment, optionally, S130 in which the multi-dimensional feature data at the n-th occasion is calculated according to the vehicle parameter information at the n-th occasion and the multi-dimensional feature data at the (n - 1)-th occasion further includes that the battery charging data at the n-th occasion is calculated according to the real-time fast charging capacity of the battery pack at the n-th occasion, the real-time slow charging capacity of the battery pack at the n-th occasion, the voltages of all the battery cells, the real-time charging temperatures of the battery pack from the (n - 1)-th occasion to the n-th occasion, and the battery charging data of the multi-dimensional feature data at the (n - 1)-th occasion.

In some embodiments, multi-dimensional feature data further includes battery charging data. With the increasing number of vehicle charging times, different charging manners and temperatures may also cause a reduction in the battery state of health to different degrees. Therefore, it is necessary to detect data including the charging capacity and charging temperature of the battery pack so as to obtain more precise battery health through the battery charging data.

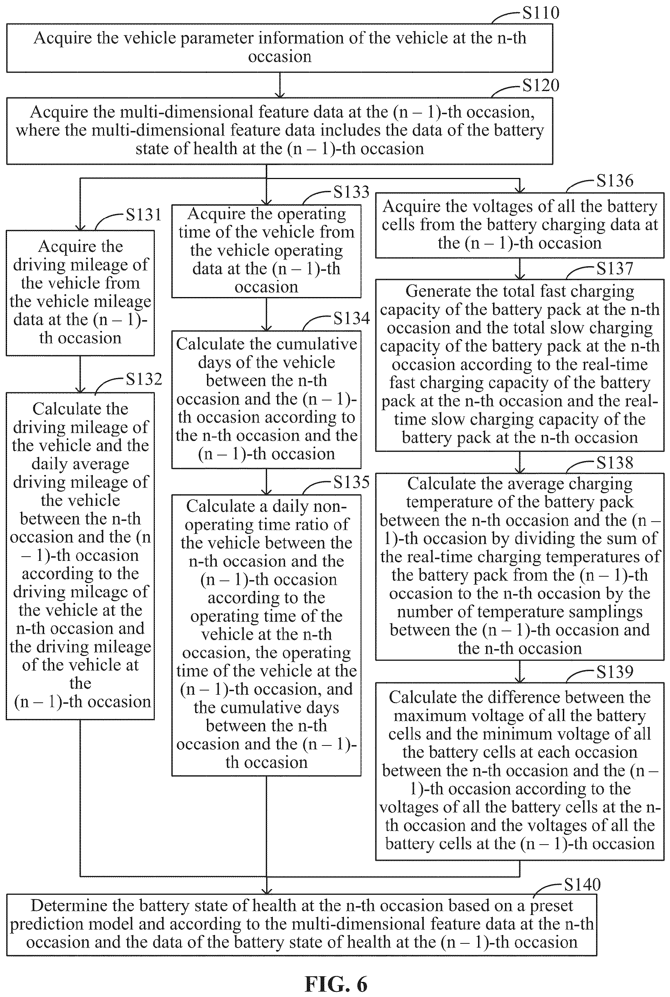

FIG. 6 is a flowchart of another method for predicting a battery state of health of a vehicle according to embodiments of the present application. Referring to FIG. 6, on the basis of each preceding embodiment, optionally, the operation of calculating the battery charging data at the n-th occasion according to the real-time fast charging capacity of the battery pack at the n-th occasion, the real-time slow charging capacity of the battery pack at the n-th occasion, the voltages of all the battery cells, the real-time charging temperatures of the battery pack from the (n - 1)-th occasion to the n-th occasion, and the battery charging data of the multi-dimensional feature data at the (n - 1)-th occasion includes the steps below.

In S136, the voltages of all the battery cells are acquired from the battery charging data at the (n - 1)-th occasion.

When the voltages of all the battery cells are acquired, the voltage of each battery cell inside the battery pack needs to be acquired when the battery pack is fully charged.

In S137, the total fast charging capacity of the battery pack at the n-th occasion and the total slow charging capacity of the battery pack at the n-th occasion are generated according to the real-time fast charging capacity of the battery pack at the n-th occasion and the real-time slow charging capacity of the battery pack at the n-th occasion.

In some embodiments, the battery charging data includes the total fast charging capacity of the battery pack, the total slow charging capacity of the battery pack, the average charging temperature, and the difference between the maximum voltage of all the battery cells and the minimum voltage of all the battery cells.

The real-time fast charging capacity of the battery pack at the n-th occasion is the total fast charging capacity of the battery pack at and before the n-th occasion. The real-time slow charging capacity of the battery pack at the n-th occasion is the total slow charging capacity of the battery pack at and before the n-th occasion. Therefore, the real-time fast charging capacity of the battery pack at the n-th occasion is the total fast charging capacity of the battery pack at the n-th occasion. The real-time slow charging capacity of the battery pack at the n-th occasion is the total slow charging capacity of the battery pack at the n-th occasion.

In S138, the average charging temperature of the battery pack between the n-th occasion and the (n - 1)-th occasion is calculated by dividing the sum of the real-time charging temperatures of the battery pack from the (n - 1)-th occasion to the n-th occasion by the number of temperature samplings between the (n - 1)-th occasion and the n-th occasion.

In some embodiments, multiple sampling points may exist between the (n - 1)-th occasion and the n-th occasion. Exemplarily, the vehicle may collect the temperature every 10 seconds. The average charging temperature of the battery pack between the n-th occasion and the (n - 1)-th occasion can be obtained by accumulating the real-time charging temperature each time and dividing the sum by the total number of temperature samplings.

In S139, the difference between the maximum voltage of all the battery cells and the minimum voltage of all the battery cells at each occasion between the n-th occasion and the (n - 1)-th occasion is calculated according to the voltages of all the battery cells at the n-th occasion and the voltages of all the battery cells at the (n - 1)-th occasion. The average value of the differences between the maximum voltages of all the battery cells and the minimum voltages of all the battery cells at all occasions is taken as a voltage difference.

Under ideal conditions, when the battery pack is fully charged, the internal battery cells should be kept at the same voltage. If the voltage of a battery cell changes, the battery capacity of the battery cell may change. Therefore, the battery state of health of the battery pack can be reflected by calculating the differences between the maximum voltages of all the battery cells and the minimum voltages of all the battery cells.

Exemplarily, the voltages of all the battery cells at the (n - 1)-th occasion may be expressed as $\{V_1^{n-1}, V_2^{n-1}, ..., V_m^{n-1}\}$. The voltages of all the battery cells at the n-th occasion may be expressed as $\{V_1^n, V_2^n, ..., V_m^n\}$. m denotes the number of battery cells. The difference between the maximum voltage of all the battery cells and the minimum voltage of all the battery cells at each occasion is calculated. For example, for the k-th occasion (k is n - 1 or n), the difference between the maximum voltage of all the battery cells and the minimum voltage of all the battery cells at the occasion is calculated and denoted as $V_{diff}^k$. That is,

$$V_{diff}^k = \max\{V_1^k, V_2^k, ..., V_m^k\} - \min\{V_1^k, V_2^k, ..., V_m^k\}$$. Then the voltage difference $\overline{V}_{diff}$ is obtained by calculating the average value of the differences between the maximum voltages of all the battery cells and the minimum voltages of all the battery cells between the (n - 1)-th occasion and the n-th occasion. That is,

$$\overline{V}_{diff} = \frac{V_{diff}^{n-1} + V_{diff}^n}{2}.$$

The technical solutions provided in embodiments of the present application do not limit the execution order of step S131, step S133, and step S136. After step S120, step S131 may be performed first; alternatively, step S133 may be performed first; alternatively, step S136 may be performed first.

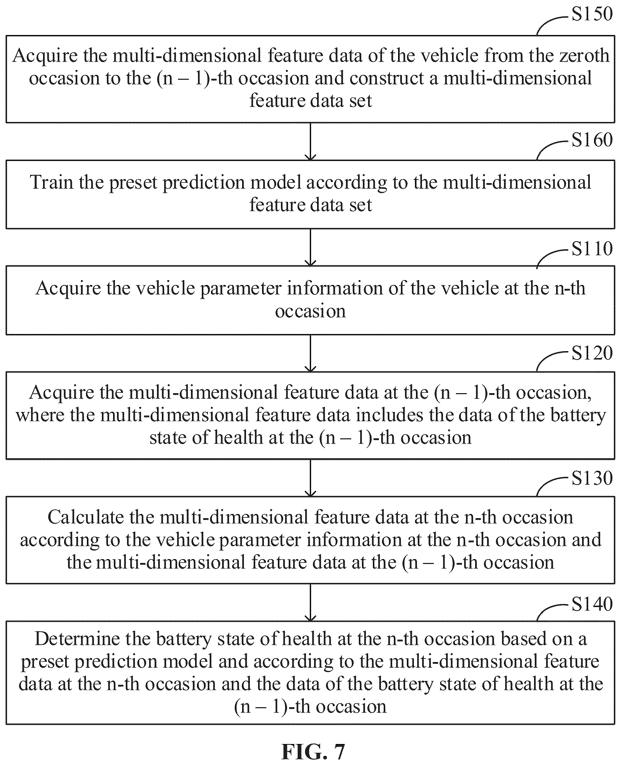

FIG. 7 is a flowchart of another method for predicting a battery state of health of a vehicle according to embodiments of the present application. Referring to FIG. 7, on the basis of each preceding embodiment, optionally, before S110 in which the vehicle parameter information of the vehicle at the n-th occasion is acquired, the method includes the steps below.

In S150, the multi-dimensional feature data of the vehicle from the zeroth occasion to the (n - 1)-th occasion is acquired, and a multi-dimensional feature data set is constructed.

Table 1 is a summary table of a multi-dimensional feature data set provided in embodiments of the present application. Referring to Table 1, driving mileage is used for representing the total driving mileage of the vehicle; interval driving mileage is used for representing the driving mileage of the vehicle between two occasions; daily average mileage is used for representing daily average driving mileage; cumulative days is used for representing the cumulative days between the current occasion and the initial occasion; interval cumulative days is used for representing the cumulative days between two occasions; non-operating ratio is used for representing the ratio of daily non-operating time between two occasions; fast charging capacity is used for representing total fast charging capacity; slow charging capacity is used for representing total slow charging capacity; voltage difference is used for representing the difference between the maximum voltage and the minimum voltage of all the battery cells at each occasion; temperature is used for representing the average charging temperature between two occasions; battery state of health at the previous occasion is used for representing the battery state of health at the previous occasion; and battery state of health is used for representing the battery state of health at the current occasion.

Table 1

| Driving Mileage/km | Interval Driving Mileage/km | Daily Average Mileage/km | Cumulative days/ Day | Interval Cumulative days/ Day | Non-operating Ratio/ % | Fast Charging Capacity/ Degree | Slow Charging Capacity/ Degree | Voltage Difference/Mil livolt (mV) | Temperature/ Celsius Degree (°C) | Battery State of Health at the Previous Occasion/% | Battery State of Health/ % |
|---|---|---|---|---|---|---|---|---|---|---|---|
| 23138.2 | 23138.2 | 324.9 | 66.51 | 66.51 | 39.594 | 1845.708 | 1919.316 | 34.463 | 21.312 | 100.00 | 98.20 |
| 27231 | 4092.8 | 323.2 | 80.33 | 13.82 | 39.807 | 2000.409 | 2485.253 | 35.006 | 24.49 | 98.20 | 97.79 |
| 60087.8 | 32856.8 | 305.1 | 192.49 | 112.2 | 44.096 | 4399.121 | 5812.599 | 35.76 | 36.518 | 97.79 | 96.83 |
| 68729 | 8641.2 | 294.7 | 228.4 | 35.91 | 45.007 | 4993.442 | 6815.776 | 35.234 | 36.086 | 96.83 | 96.03 |
| 71188 | 2459 | 295.1 | 236.31 | 7.91 | 44.486 | 5046.955 | 7203.635 | 35.186 | 36.582 | 96.03 | 95.92 |
| 79264.4 | 8076.4 | 295.5 | 263.2 | 26.89 | 44.591 | 6031.494 | 7724.882 | 34.74 | 36.299 | 95.92 | 95.24 |
| 90059.3 | 10795 | 300.1 | 295.29 | 32.09 | 44.059 | 7025.687 | 8708.705 | 34.937 | 35.534 | 95.24 | 94.99 |
| 91574 | 1514.7 | 299.1 | 301.31 | 6.03 | 44.079 | 7127.206 | 8891.027 | 34.851 | 38.084 | 94.99 | 94.85 |
| 95504 | 3930 | 301.2 | 312.29 | 10.97 | 43.563 | 7318.249 | 9371.497 | 34.911 | 37.312 | 94.85 | 94.77 |
| 97367.6 | 1863.6 | 301.4 | 318.24 | 5.95 | 43.338 | 7410.594 | 9626.929 | 34.866 | 38.034 | 94.77 | 94.79 |
| 106381.1 | 9013.5 | 300.1 | 349.51 | 31.27 | 43.358 | 8325.97 | 10364.232 | 34.459 | 31.99 | 94.79 | 94.79 |
| 109845.1 | 3464 | 301.7 | 359.37 | 9.87 | 42.926 | 8481.453 | 10815.52 | 34.472 | 34.518 | 94.79 | 94.69 |
| 112193 .9 | 2348.8 | 298.3 | 371.4 | 12.02 | 43.274 | 8717.1 46 | 11024. 85 | 34.16 | 31.573 | 94.69 | 94.45 |
| 115453 .1 | 3259.2 | 295.9 | 385.31 | 13.91 | 43.578 | 8958.8 16 | 11392. 503 | 34.115 | 33.179 | 94.45 | 94.41 |
| 119404 .6 | 3951.5 | 296.9 | 397.34 | 12.04 | 43.369 | 9317.1 87 | 11741. 725 | 34.037 | 28.694 | 94.41 | 94.31 |

Exemplarily, the multi-dimensional feature data set may be constructed by feature engineering. Through the feature engineering, features valuable for the training and prediction of the preset prediction model may be extracted by processing and converting the original vehicle parameter information; moreover, the multi-dimensional feature data is generated to improve the performance and effect of the model.

In S160, the preset prediction model is trained according to the multi-dimensional feature data set.

The preset prediction model may be used for calculating the battery state of health. Before the preset prediction model is put into operation, the preset prediction model may be trained first. Exemplarily, after the multi-dimensional feature data is summarized into the multi-dimensional feature data set, the preset prediction model is trained through the multi-dimensional feature data set, thereby improving the prediction precision of the preset prediction model and enabling the prediction model to output data with high accuracy. After the training of the preset prediction model is completed, the multi-dimensional feature data at the n-th occasion and the data of the battery state of health at the (n - 1)-th occasion may be input into the preset prediction model. The preset prediction model may output the battery state of health at the n-th occasion.

The multi-dimensional feature data set provided in embodiments of the present application is not limited to the multi-dimensional feature data provided in Table 1 and, in other embodiments, may further include multi-dimensional feature data indicating the average vehicle speed and average battery pack voltage value between two occasions. The prediction accuracy of the preset prediction model can be improved by adding the multi-dimensional feature data and training the preset prediction model. Therefore, the prediction model can output the battery state of health with high accuracy when predicting the battery state of health.

On the basis of each preceding embodiment, optionally, S150 in which the multi-dimensional feature data of the vehicle from the zeroth occasion to the (n - 1)-th occasion is acquired includes acquiring the multi-dimensional feature data of at least two vehicles from the zeroth occasion to the (n - 1)-th occasion. The data of the battery state of health at the zeroth occasion is a preset initial health value.

Exemplarily, when the model is trained, the multi-dimensional feature data of multiple vehicles may be input into the preset prediction model to guarantee the precision of the prediction result of the model to the greatest degree. With this configuration, the multi-dimensional feature data of different vehicles in different use environments can be calculated and collected so that the preset prediction model provided in embodiments of the present application can accurately predict the battery state of health in different vehicle use scenarios and has a better prediction performance.

Exemplarily, the data of the battery state of health in the multi-dimensional feature data at the zeroth occasion is the preset initial health value. The preset initial health value is used for indicating the initial battery state of health. For example, the preset initial health value may be 100%.

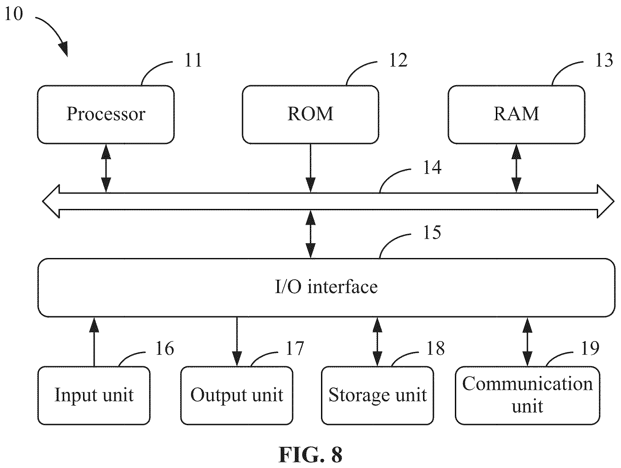

FIG. 8 is a diagram illustrating the structure of an electronic device for implementing embodiments of this application. The electronic device is intended to represent various forms of digital computers, for example, a laptop computer, a desktop computer, a worktable, a personal digital assistant, a server, a blade server, a mainframe computer, and another applicable computer. The electronic device may also represent various forms of mobile apparatuses, for example, a personal digital assistant, a cellphone, a smartphone, a wearable device (such as a helmet, glasses, or a watch), and another similar computing apparatus. Herein the shown components, the connections and relationships between these components, and the functions of these components are illustrative.

As shown in FIG. 8, the electronic device 10 includes at least one processor 11 and a memory communicatively connected to the at least one processor 11, such as a read-only memory (ROM) 12 and a random-access memory (RAM) 13. The memory stores a computer program executable by the at least one processor. The at least one processor 11 can perform various appropriate actions and processing according to a computer program stored in the read-only memory (ROM) 12 or a computer program loaded into the random-access memory (RAM) 13 from a storage unit 18. Various programs and data required for the operation of the electronic device 10 may also be stored in the RAM 13. At least one processor 11, the ROM 12, and the RAM 13 are connected to each other through a bus 14. An input/output (I/O) interface 15 is also connected to the bus 14.

Multiple components in the electronic device 10 are connected to the I/O interface 15. The multiple components include an input unit 16 such as a keyboard or a mouse, an output unit 17 such as various types of displays or speakers, the storage unit 18 such as a magnetic disk or an optical disc, and a communication unit 19 such as a network card, a modem, or a wireless communication transceiver. The communication unit 19 allows the electronic device 10 to exchange information/data with other devices over a computer network such as the Internet and/or various telecommunications networks.

The at least one processor 11 may be various general-purpose and/or special-purpose processing components having processing and computing capabilities. Examples of the processor 11 include, but are not limited to, a central processing unit (CPU), a graphics processing unit (GPU), a special-purpose artificial intelligence (AI) computing chip, a processor executing machine learning models and algorithms, a digital signal processor (DSP), and any appropriate processor, controller, or microcontroller. The processor 11 performs various preceding methods and processing, such as the method for predicting a battery state of health of a vehicle.

In some embodiments, the method for predicting a battery state of health of a vehicle may be implemented as computer programs tangibly contained in a computer-readable storage medium such as the storage unit 18. In some embodiments, part or all of computer programs may be loaded and/or installed onto the electronic device 10 via the ROM 12 and/or the communication unit 19. When the computer programs are loaded to the RAM 13 and executed by the processor 11, one or more steps of the preceding method for predicting a battery state of health of a vehicle may be performed. Alternatively, in other embodiments, the processor 11 may be configured, in any other suitable manner (for example, by means of firmware), to perform the method for predicting a battery state of health of a vehicle.

The various embodiments of the systems and techniques described herein may be implemented in digital electronic circuitry, integrated circuitry, a field-programmable gate array (FPGA), an application-specific integrated circuit (ASIC), application specific standard parts (ASSP), a system on a chip (SoC), a complex programmable logic device (CPLD), computer hardware, firmware, software, and/or a combination thereof. The various embodiments may include implementations in one or more computer programs. The one or more computer programs are executable and/or interpretable on a programmable system including at least one programmable processor. The programmable processor may be a dedicated or general-purpose programmable processor for receiving data and instructions from a memory system, at least one input apparatus and at least one output apparatus and transmitting data and instructions to the memory system, the at least one input apparatus, and the at least one output apparatus.

Computer programs for implementation of the methods of the present application may be written in one programming language or any combination of multiple programming languages. These computer programs may be provided for a processor of a general-purpose computer, a special-purpose computer, or another programmable data processing apparatus to enable functions/operations specified in a flowchart and/or a block diagram to be implemented when the computer programs are executed by the processor. The computer programs may be executed entirely on a machine, partly on a machine, as a stand-alone software package, partly on a machine and partly on a remote machine, or entirely on a remote machine or a server.

In the context of the present application, the computer-readable storage medium may be a tangible medium that may include or store a computer program used by or in conjunction with an instruction execution system, apparatus, or device. The computer-readable storage medium may include an electronic, magnetic, optical, electromagnetic, infrared, or semiconductor system, apparatus, or device or any appropriate combination thereof. Alternatively, the computer-readable storage medium may be a machine-readable signal medium. Examples of the machine-readable storage medium may include an electrical connection based on one or more wires, a portable computer disk, a hard disk, a random-access memory (RAM), a read-only memory (ROM), an erasable programmable read-only memory (EPROM), a flash memory, an optical fiber, a portable compact disk read-only memory (CD-ROM), an optical memory device, a magnetic memory device or any suitable combination thereof.

In order to provide the interaction with a user, the systems and techniques described herein may be implemented in the electronic device. The electronic device has a display apparatus (for example, a cathode-ray tube (CRT) or a liquid-crystal display (LCD) monitor) for displaying information to the user; and a keyboard and a pointing apparatus (for example, a mouse or a trackball) through which the user can provide input for the electronic device. Other types of apparatuses may also be used for providing interaction with the user. For example, feedback provided for the user may be sensory feedback in any form (for example, visual feedback, auditory feedback, or tactile feedback); and input from the user may be received in any form (including acoustic input, voice input, or tactile input).

The systems and techniques described herein may be implemented in a computing system including a back-end component (for example, a data server), a computing system including a middleware component (for example, an application server), a computing system including a front-end component (for example, a client computer having a graphical user interface or a web browser through which the user can interact with embodiments of the systems and techniques described herein), or a computing system including any combination of such back-end, middleware, or front-end components. Components of a system may be interconnected by any form or medium of digital data communication (for example, a communication network). Examples of the communication network include a local area network (LAN), a wide area network (WAN), a blockchain network, and the Internet.

The computing system may include clients and servers. A client and a server are generally remote from each other and typically interact through a communication network. The relationship between the client and the server arises by virtue of computer programs running on respective computers and having a client-server relationship to each other The server may be a cloud server, also referred to as a cloud computing server or a cloud host. As a host product in a cloud computing service system, the server solves the defects of difficult management and weak service scalability in conventional physical host and virtual private server (VPS) services.

It is to be understood that various forms of the preceding flows may be used with steps reordered, added, or deleted. For example, the steps described in the present application may be executed in parallel, in sequence, or in a different order as long as the desired results of the technical solutions of the present application can be achieved.

**Claims**

1. A method for predicting a battery state of health of a vehicle, comprising:

   acquiring vehicle parameter information of the vehicle at an n-th occasion, wherein the vehicle parameter information comprises operating parameters of the vehicle and parameter information of a battery pack, and n is an integer greater than or equal to 1;

   acquiring multi-dimensional feature data at an (n - 1)-th occasion, wherein the multi-dimensional feature data comprises data of a battery state of health at the (n - 1)-th occasion;

   calculating multi-dimensional feature data at the n-th occasion according to the vehicle parameter information at the n-th occasion and the multi-dimensional feature data at the (n - 1)-th occasion; and

   determining a battery state of health at the n-th occasion based on a preset prediction model and according to the multi-dimensional feature data at the n-th occasion and the data of the battery state of health at the (n - 1)-th occasion.

2. The method for predicting the battery state of health of the vehicle according to claim 1, wherein acquiring the vehicle parameter information of the vehicle at the n-th occasion comprises:

   acquiring the operating parameters of the vehicle and the parameter information of the battery pack at the n-th occasion;

   wherein the operating parameters of the vehicle comprise driving mileage of the vehicle and operating time of the vehicle; and

   the parameter information of the battery pack comprises a real-time charging temperature of the battery pack, a real-time fast charging capacity of the battery pack, a real-time slow charging capacity of the battery pack, and voltages of all battery cells.

3. The method for predicting the battery state of health of the vehicle according to claim 1, wherein calculating the multi-dimensional feature data at the n-th occasion according to the vehicle parameter information at the n-th occasion and the multi-dimensional feature data at the (n - 1)-th occasion comprises:
   calculating vehicle mileage data at the n-th occasion according to the driving mileage of the vehicle at the n-th occasion and vehicle mileage data of the multi-dimensional feature data at the (n - 1)-th occasion.

4. The method for predicting the battery state of health of the vehicle according to any one of claims 1 to 3, wherein calculating the vehicle mileage data at the n-th occasion according to the driving mileage of the vehicle at the n-th occasion and the vehicle mileage data of the multi-dimensional feature data at the (n - 1)-th occasion comprises:

   acquiring driving mileage of the vehicle from the vehicle mileage data at the (n - 1)-th occasion; and

   calculating driving mileage of the vehicle and daily average driving mileage of the vehicle between the n-th occasion and the (n - 1)-th occasion according to the driving mileage of the vehicle at the n-th occasion and the driving mileage of the vehicle at the (n - 1)-th occasion, wherein the vehicle mileage data comprises driving mileage and daily average driving mileage.

5. The method for predicting the battery state of health of the vehicle according to claim 4, wherein calculating the driving mileage of the vehicle and the daily average driving mileage of the vehicle between the n-th occasion and the (n - 1)-th occasion according to the driving mileage of the vehicle at the n-th occasion and the driving mileage of the vehicle at the (n - 1)-th occasion comprises:

   calculating the driving mileage of the vehicle between the n-th occasion and the (n - 1)-th occasion according to a difference between the driving mileage of the vehicle at the n-th occasion and the driving mileage of the vehicle at the (n - 1)-th occasion;

   calculating cumulative days of the vehicle between the n-th occasion and the (n - 1)-th occasion according to a time difference between the n-th occasion and the (n - 1)-th occasion; and

   calculating the daily average driving mileage according to a ratio of the driving mileage to the cumulative days.

6. The method for predicting the battery state of health of the vehicle according to claim 1 or 2, wherein calculating the multi-dimensional feature data at the n-th occasion according to the vehicle parameter information at the n-th occasion and the multi-dimensional feature data at the (n - 1)-th occasion further comprises:
   calculating vehicle operating data at the n-th occasion according to operating time of the vehicle at the n-th occasion and vehicle operating data of the multi-dimensional feature data at the (n - 1)-th occasion.

7. The method for predicting the battery state of health of the vehicle according to claim 6, wherein calculating the vehicle operating data at the n-th occasion according to the operating time of the vehicle at the n-th occasion and the vehicle operating data of the multi-dimensional feature data at the (n - 1)-th occasion comprises:

acquiring operating time of the vehicle from the vehicle operating data at the (n - 1)-th occasion;
calculating cumulative days of the vehicle between the n-th occasion and the (n - 1)-th occasion according to the n-th occasion and the (n - 1)-th occasion; and
calculating a daily non-operating time ratio of the vehicle between the n-th occasion and the (n - 1)-th occasion according to the operating time of the vehicle at the n-th occasion, the operating time of the vehicle at the (n - 1)-th occasion, and the cumulative days between the n-th occasion and the (n - 1)-th occasion, wherein the vehicle operating data comprises a daily non-operating time ratio.

8. The method for predicting the battery state of health of the vehicle according to claim 7, wherein calculating the daily non-operating time ratio of the vehicle between the n-th occasion and the (n - 1)-th occasion according to the operating time of the vehicle at the n-th occasion, the operating time of the vehicle at the (n - 1)-th occasion, and the cumulative days between the n-th occasion and the (n - 1)-th occasion comprises:

calculating non-operating time of the vehicle according to a difference between a total duration corresponding to the cumulative days and a total duration of operating time of the vehicle between the n-th occasion and the (n - 1)-th occasion; and
calculating the daily non-operating time ratio of the vehicle between the n-th occasion and the (n - 1)-th occasion according to a ratio of the non-operating time of the vehicle to the cumulative days.

9. The method for predicting the battery state of health of the vehicle according to claim 1 or 2, wherein calculating the multi-dimensional feature data at the n-th occasion according to the vehicle parameter information at the n-th occasion and the multi-dimensional feature data at the (n - 1)-th occasion further comprises:
calculating battery charging data at the n-th occasion according to a real-time fast charging capacity of the battery pack at the n-th occasion, a real-time slow charging capacity of the battery pack at the n-th occasion, voltages of all battery cells, real-time charging temperatures of the battery pack from the (n - 1)-th occasion to the n-th occasion, and battery charging data of the multi-dimensional feature data at the (n - 1)-th occasion.

10. The method for predicting the battery state of health of the vehicle according to claim 9, wherein calculating the battery charging data at the n-th occasion according to the real-time fast charging capacity of the battery pack at the n-th occasion, the real-time slow charging capacity of the battery pack at the n-th occasion, the voltages of the all battery cells, the real-time charging temperatures of the battery pack from the (n - 1)-th occasion to the n-th occasion, and the battery charging data of the multi-dimensional feature data at the (n - 1)-th occasion comprises:

acquiring voltages of the all battery cells from the battery charging data at the (n - 1)-th occasion;
generating a total fast charging capacity of the battery pack at the n-th occasion and a total slow charging capacity of the battery pack at the n-th occasion according to the real-time fast charging capacity of the battery pack at the n-th occasion and the real-time slow charging capacity of the battery pack at the n-th occasion;
calculating an average charging temperature of the battery pack between the n-th occasion and the (n - 1)-th occasion by dividing a sum of the real-time charging temperatures of the battery pack from the (n - 1)-th occasion to the n-th occasion by a number of temperature samplings between the (n - 1)-th occasion and the n-th occasion; and
calculating a difference between a maximum voltage of the all battery cells and a minimum voltage of the all battery cells between the n-th occasion and the (n - 1)-th occasion according to the voltages of the all battery cells at the n-th occasion and voltages of the all battery cells at the (n - 1)-th occasion;
wherein the battery charging data comprises a total fast charging capacity of the battery pack, a total slow charging capacity of the battery pack, an average charging temperature, and a difference between a maximum voltage of the all battery cells and a minimum voltage of the all battery cells.

11. The method for predicting the battery state of health of the vehicle according to claim 1, before acquiring the vehicle parameter information of the vehicle at the n-th occasion, further comprising:

acquiring multi-dimensional feature data of the vehicle from a zeroth occasion to the (n - 1)-th occasion and constructing a multi-dimensional feature data set; and
training the preset prediction model according to the multi-dimensional feature data set.

**12.** The method for predicting the battery state of health of the vehicle according to claim 11, wherein acquiring the multi-dimensional feature data of the vehicle from the zeroth occasion to the (n - 1)-th occasion comprises:

acquiring multi-dimensional feature data of at least two vehicles from the zeroth occasion to the (n - 1)-th occasion,
wherein data of a battery state of health at the zeroth occasion is a preset initial health value.

**13.** An electronic device, comprising:

at least one processor; and
a memory communicatively connected to the at least one processor,
wherein the memory stores a computer program executable by the at least one processor; and the computer program, when executed by the at least one processor, causes the at least one processor to perform the method for predicting the battery state of health of the vehicle according to any one of claims 1 to 12.

**14.** A computer-readable storage medium for storing computer instructions which, when executed by a processor, cause the processor to perform the method for predicting the battery state of health of the vehicle according to any one of claims 1 to 12.

$\overline{\phantom{x}}$S110

| Acquire the vehicle parameter information of the vehicle at the n-th occasion |
|---|

↓ $\overline{\phantom{x}}$S120

| Acquire the multi-dimensional feature data at the (n − 1)-th occasion, where the multi-dimensional feature data includes the data of the battery state of health at the (n − 1)-th occasion |
|---|

↓ $\overline{\phantom{x}}$S130

| Calculate the multi-dimensional feature data at the n-th occasion according to the vehicle parameter information at the n-th occasion and the multi-dimensional feature data at the (n − 1)-th occasion |
|---|

↓ $\overline{\phantom{x}}$S140

| Determine the battery state of health at the n-th occasion based on a preset prediction model and according to the multi-dimensional feature data at the n-th occasion and the data of the battery state of health at the (n − 1)-th occasion |
|---|

**FIG. 1**

S110

Acquire the vehicle parameter information of the vehicle at the n-th occasion

S120

Acquire the multi-dimensional feature data at the (n − 1)-th occasion, where the multi-dimensional feature data includes the data of the battery state of health at the (n − 1)-th occasion

S131

Acquire the driving mileage of the vehicle from the vehicle mileage data at the (n − 1)-th occasion

S132

Calculate the driving mileage of the vehicle and the daily average driving mileage of the vehicle between the n-th occasion and the (n − 1)-th occasion according to the driving mileage of the vehicle at the n-th occasion and the driving mileage of the vehicle at the (n − 1)-th occasion

S140

Determine the battery state of health at the n-th occasion based on a preset prediction model and according to the multi-dimensional feature data at the n-th occasion and the data of the battery state of health at the (n − 1)-th occasion

**FIG. 2**

S1321

Calculate the driving mileage of the vehicle between the n-th occasion and the (n − 1)-th occasion according to the difference between the driving mileage of the vehicle at the n-th occasion and the driving mileage of the vehicle at the (n − 1)-th occasion

S1322

Calculate the cumulative days of the vehicle between the n-th occasion and the (n − 1)-th occasion according to the time difference between the n-th occasion and the (n − 1)-th occasion

S1323

Calculate the daily average driving mileage according to a ratio of the driving mileage to the cumulative days

**FIG. 3**

```
                                                           ┌─ S110
┌──────────────────────────────────────────────────────────────────┐
│   Acquire the vehicle parameter information of the vehicle at the  │
│                       n-th occasion                                │
└──────────────────────────────────────────────────────────────────┘
                                │
                                ▼                          ┌─ S120
┌──────────────────────────────────────────────────────────────────┐
│  Acquire the multi-dimensional feature data at the (n − 1)-th      │
│  occasion, where the multi-dimensional feature data includes the   │
│  data of the battery state of health at the (n − 1)-th occasion    │
└──────────────────────────────────────────────────────────────────┘
```

Acquire the operating time of the vehicle from the vehicle operating data at the (n − 1)-th occasion — S133

Acquire the driving mileage of the vehicle from the vehicle mileage data at the (n − 1)-th occasion — S131

Calculate the cumulative days of the vehicle between the n-th occasion and the (n − 1)-th occasion according to the n-th occasion and the (n − 1)-th occasion — S134

Calculate the driving mileage of the vehicle and the daily average driving mileage of the vehicle between the n-th occasion and the (n − 1)-th occasion according to the driving mileage of the vehicle at the n-th occasion and the driving mileage of the vehicle at the (n − 1)-th occasion — S132

Calculate a daily non-operating time ratio of the vehicle between the n-th occasion and the (n − 1)-th occasion according to the operating time of the vehicle at the n-th occasion, the operating time of the vehicle at the (n − 1)-th occasion, and the cumulative days between the n-th occasion and the (n − 1)-th occasion — S135

Determine the battery state of health at the n-th occasion based on a preset prediction model and according to the multi-dimensional feature data at the n-th occasion and the data of the battery state of health at the (n − 1)-th occasion — S140

**FIG. 4**

S1351

Calculate the non-operating time of the vehicle according to the difference between the total duration corresponding to the cumulative days and the total duration of the operating time of the vehicle between the n-th occasion and the (n − 1)-th occasion

S1352

Calculate the daily non-operating time ratio of the vehicle between the n-th occasion and the (n − 1)-th occasion according to a ratio of the non-operating time of the vehicle to the cumulative days

**FIG. 5**

S110

Acquire the vehicle parameter information of the vehicle at the n-th occasion

S120

Acquire the multi-dimensional feature data at the (n − 1)-th occasion, where the multi-dimensional feature data includes the data of the battery state of health at the (n − 1)-th occasion

S131

Acquire the driving mileage of the vehicle from the vehicle mileage data at the (n − 1)-th occasion

S132

Calculate the driving mileage of the vehicle and the daily average driving mileage of the vehicle between the n-th occasion and the (n − 1)-th occasion according to the driving mileage of the vehicle at the n-th occasion and the driving mileage of the vehicle at the (n − 1)-th occasion

S133

Acquire the operating time of the vehicle from the vehicle operating data at the (n − 1)-th occasion

S134

Calculate the cumulative days of the vehicle between the n-th occasion and the (n − 1)-th occasion according to the n-th occasion and the (n − 1)-th occasion

S135

Calculate a daily non-operating time ratio of the vehicle between the n-th occasion and the (n − 1)-th occasion according to the operating time of the vehicle at the n-th occasion, the operating time of the vehicle at the (n − 1)-th occasion, and the cumulative days between the n-th occasion and the (n − 1)-th occasion

S136

Acquire the voltages of all the battery cells from the battery charging data at the (n − 1)-th occasion

S137

Generate the total fast charging capacity of the battery pack at the n-th occasion and the total slow charging capacity of the battery pack at the n-th occasion according to the real-time fast charging capacity of the battery pack at the n-th occasion and the real-time slow charging capacity of the battery pack at the n-th occasion

S138

Calculate the average charging temperature of the battery pack between the n-th occasion and the (n − 1)-th occasion by dividing the sum of the real-time charging temperatures of the battery pack from the (n − 1)-th occasion to the n-th occasion by the number of temperature samplings between the (n − 1)-th occasion and the n-th occasion

S139

Calculate the difference between the maximum voltage of all the battery cells and the minimum voltage of all the battery cells at each occasion between the n-th occasion and the (n − 1)-th occasion according to the voltages of all the battery cells at the n-th occasion and the voltages of all the battery cells at the (n − 1)-th occasion

S140

Determine the battery state of health at the n-th occasion based on a preset prediction model and according to the multi-dimensional feature data at the n-th occasion and the data of the battery state of health at the (n − 1)-th occasion

**FIG. 6**

```
                                                                    ┌─ S150
┌──────────────────────────────────────────────────────────────────┐
│  Acquire the multi-dimensional feature data of the vehicle from    │
│  the zeroth occasion to the (n − 1)-th occasion and construct a     │
│  multi-dimensional feature data set                                │
└──────────────────────────────────────────────────────────────────┘
                                │
                                ▼                                   ┌─ S160
┌──────────────────────────────────────────────────────────────────┐
│  Train the preset prediction model according to the multi-         │
│  dimensional feature data set                                      │
└──────────────────────────────────────────────────────────────────┘
                                │
                                ▼                                   ┌─ S110
┌──────────────────────────────────────────────────────────────────┐
│  Acquire the vehicle parameter information of the vehicle at the    │
│  n-th occasion                                                     │
└──────────────────────────────────────────────────────────────────┘
                                │
                                ▼                                   ┌─ S120
┌──────────────────────────────────────────────────────────────────┐
│  Acquire the multi-dimensional feature data at the (n − 1)-th       │
│  occasion, where the multi-dimensional feature data includes the   │
│  data of the battery state of health at the (n − 1)-th occasion     │
└──────────────────────────────────────────────────────────────────┘
                                │
                                ▼                                   ┌─ S130
┌──────────────────────────────────────────────────────────────────┐
│  Calculate the multi-dimensional feature data at the n-th occasion  │
│  according to the vehicle parameter information at the n-th         │
│  occasion and the multi-dimensional feature data at the            │
│  (n − 1)-th occasion                                               │
└──────────────────────────────────────────────────────────────────┘
                                │
                                ▼                                   ┌─ S140
┌──────────────────────────────────────────────────────────────────┐
│  Determine the battery state of health at the n-th occasion based   │
│  on a preset prediction model and according to the multi-           │
│  dimensional feature data at the n-th occasion and the data of the  │
│  battery state of health at the (n − 1)-th occasion                 │
└──────────────────────────────────────────────────────────────────┘
```

**FIG. 7**

10

| 11 | 12 | 13 |
| :---: | :---: | :---: |
| Processor | ROM | RAM |

14

15

I/O interface

| 16 | 17 | 18 | 19 |
| :---: | :---: | :---: | :---: |
| Input unit | Output unit | Storage unit | Communication unit |

**FIG. 8**

## INTERNATIONAL SEARCH REPORT

| International application No. |
|---|
| **PCT/CN2025/097529** |

**A. CLASSIFICATION OF SUBJECT MATTER**

G01R 31/392(2019.01)i; G01R 31/396(2019.01)i; G01R 31/367(2019.01)i

According to International Patent Classification (IPC) or to both national classification and IPC

**B. FIELDS SEARCHED**

Minimum documentation searched (classification system followed by classification symbols)

IPC: G01R

Documentation searched other than minimum documentation to the extent that such documents are included in the fields searched

Electronic data base consulted during the international search (name of data base and, where practicable, search terms used)

CNTXT; ENTXTC; ENTXT: 电池, 健康, 多维, 特征, 时刻, 里程, 运行, 行驶, 时间, 电量, battery, health, SOH, multiple, feature, time, moment, mileage, quantity of electricity

**C. DOCUMENTS CONSIDERED TO BE RELEVANT**

| Category* | Citation of document, with indication, where appropriate, of the relevant passages | Relevant to claim No. |
|---|---|---|
| Y | CN 117518010 A (CHONGQING SERES NEW ENERGY AUTOMOBILE DESIGN INSTITUTE CO., LTD.) 06 February 2024 (2024-02-06) claims 1-2 and 10-11, and description, paragraphs 44-157 | 1-14 |
| Y | CN 115219919 A (ZHEJIANG ZEEKR INTELLIGENT TECHNOLOGY CO., LTD. et al.) 21 October 2022 (2022-10-21) description, paragraphs 82-159 | 1-14 |
| A | CN 112666464 A (BEIJING DIDI INFINITY TECHNOLOGY AND DEVELOPMENT CO., LTD.) 16 April 2021 (2021-04-16) entire document | 1-14 |
| A | CN 118163671 A (SUNWODA POWER TECHNOLOGY CO., LTD.) 11 June 2024 (2024-06-11) entire document | 1-14 |
| A | CN 118625143 A (ZHUHAI NANFANG ZHIYUN AUTOMOTIVE TECHNOLOGY CO., LTD.) 10 September 2024 (2024-09-10) entire document | 1-14 |

☑ Further documents are listed in the continuation of Box C. ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **29 December 2025** | **29 December 2025** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2025/097529** |

**C. DOCUMENTS CONSIDERED TO BE RELEVANT**

| Category* | Citation of document, with indication, where appropriate, of the relevant passages | Relevant to claim No. |
| --- | --- | --- |
| A | US 2025044359 A1 (TOYOTA MOTOR ENGINEERING & MANUFACTURING NORTH AMERICA, INC. et al.) 06 February 2025 (2025-02-06)<br>entire document | 1-14 |
| A | WO 2021170345 A1 (RENAULT S.A.S) 02 September 2021 (2021-09-02)<br>entire document | 1-14 |

Form PCT/ISA/210 (second sheet) (July 2022)

## INTERNATIONAL SEARCH REPORT
### Information on patent family members

International application No.

**PCT/CN2025/097529**

| Patent document cited in search report | | | Publication date (day/month/year) | Patent family member(s) | | | Publication date (day/month/year) |
|---|---|---|---|---|---|---|---|
| CN | 117518010 | A | 06 February 2024 | None | | | |
| CN | 115219919 | A | 21 October 2022 | None | | | |
| CN | 112666464 | A | 16 April 2021 | None | | | |
| CN | 118163671 | A | 11 June 2024 | None | | | |
| CN | 118625143 | A | 10 September 2024 | None | | | |
| US | 2025044359 | A1 | 06 February 2025 | None | | | |
| WO | 2021170345 | A1 | 02 September 2021 | KR | 20220147089 | A | 02 November 2022 |
| | | | | FR | 3107597 | A1 | 27 August 2021 |
| | | | | FR | 3107597 | B1 | 28 January 2022 |
| | | | | EP | 4111219 | A1 | 04 January 2023 |
| | | | | EP | 4111219 | B1 | 03 April 2024 |

Form PCT/ISA/210 (patent family annex) (July 2022)

**EP 4 745 603 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202510425713